# EUROPÄISCHE PATENTSCHRIFT

(11) **EP 2 285 733 B1**
(45) Veröffentlichungstag und Bekanntmachung des Hinweises auf die Patenterteilung: **25.07.2018**
(21) Anmeldenummer: 08874259.8
(22) Anmeldetag: 02.12.2008
(51) Int. Cl.: B81C 1/00

(54) **VERFAHREN ZUR HERSTELLUNG VON CHIPS**
METHOD FOR PRODUCING CHIPS
PROCÉDÉ DE FABRICATION DE PUCES

(30) Priorität: 14.05.2008 DE 102008001738
(43) Veröffentlichungstag der Anmeldung: 23.02.2011
(73) Patentinhaber: Robert Bosch GmbH, 70442 Stuttgart (DE)
(72) Erfinder: KRAMER, Torsten, 72827 Wannweil (DE); BOEHRINGER, Matthias, 72768 Reutlingen (DE); PINTER, Stefan, 72764 Reutlingen (DE); BENZEL, Hubert, 72124 Pliezhausen (DE); ILLING, Matthias, Palo Alto 94304 (US); HAAG, Frieder, 72827 Wannweil (DE); ARMBRUSTER, Simon, 72810 Gomaringen (DE)
(86) Internationale Anmeldenummer: PCT/EP2008/066593
(87) Internationale Veröffentlichungsnummer: WO 2009/138138

(56) Entgegenhaltungen:
- WO-A1-03/083930
- WO-A1-2007/104443
- DE-A1- 10 246 053
- US-A- 5 391 257

## Beschreibung

### Stand der Technik

Die Erfindung betrifft ein Verfahren zur Herstellung von Chips ausgehend von einem Halbleitersubstrat, bei dem in der Oberflächenschicht des Substrats mindestens eine Membran erzeugt wird, die eine Kaverne überspannt, bei dem die Funktionalität des Chips in die Membran integriert wird, und bei dem die Membran aus dem Substratverbund gelöst wird, um den Chip zu vereinzeln.

Ein derartiges Verfahren zum Herstellen bzw. Vereinzeln von Halbleiterchips wird in der DE 103 50 036 A1 beschrieben. Das bekannte Verfahren sieht vor, mit Hilfe von oberflächenmikromechanischen Prozessen Membranbereiche in der Oberfläche eines Halbleitersubstrats zu erzeugen, die jeweils eine Kaverne überspannen und lediglich über Stützstellen mit dem darunter liegenden Substrat verbunden sind. Die Oberfläche des Halbleitersubstrats wird dann weiter prozessiert, um auf den einzelnen Membranbereichen die gewünschte Chipfunktionalität zu realisieren. Das Vereinzeln der Chips erfolgt in zwei Schritten. Im ersten Schritt werden die Chips seitlich aus ihrem Verbund gelöst. Dazu werden Ätzgräben erzeugt, die in die Kavernen unterhalb der Membranbereiche münden. Erst im zweiten Schritt werden die Chips vom darunter liegenden Substrat gelöst, indem die Stützstellen in einem mechanischen Abgreifschritt (Pick and Place-Verfahren) aufgebrochen werden. Im Gegensatz zu einem Sägeprozess werden die Chips hier also nicht seriell sondern parallel vereinzelt, ohne Wassereinwirkung und ohne dass verunreinigende Partikel entstehen, die sich in der Chipstruktur festsetzten. Das aus der DE 103 50 036 bekannte Verfahren ist deshalb auch für die Herstellung sehr dünner Chips mit beliebiger Form geeignet.

### Offenbarung der Erfindung

Ausgehend von dem aus der DE 103 50 036 bekannten Verfahren wird mit der vorliegenden Erfindung eine einfache Möglichkeit zum Erzeugen einer Rückseitenmetallisierung von Chips vorgeschlagen.

Erfindungsgemäß wird die Chiprückseite dazu vor dem Herauslösen des Chips aus dem Substratverbund in einem Galvanikprozess metallisiert.

Erfindungsgemäß ist erkannt worden, dass Galvanikprozesse auch im Rahmen der Chipherstellung zur Metallisierung von Oberflächen eingesetzt werden können und sich insbesondere gut zur Beschichtung von strukturierten Oberflächen eignen. Dabei wird ausgenutzt, dass bei Galvanikprozessen grundsätzlich an allen leitfähigen Oberflächen eine Metallabscheidung auftritt, also auch an den in der Mikromechanik verwendeten Halbleitermaterialien.

Das erfindungsgemäße Verfahren erweist sich gegenüber den üblicherweise in der Chip-Technologie eingesetzten Metallisierungsverfahren, wie z.B. Sputtern, in mehrerlei Hinsicht als vorteilhaft. So erfordert der vorgeschlagene Galvanikprozess zum Erzeugen der Rückseitenmetallisierung kein aufwendiges Vorderseitenhandling von bereits vereinzelten Chips. Stattdessen wird das Halbleitersubstrat einfach in ein geeignetes Galvanikbad getaucht, nachdem die Chipfunktionalität in den Membranbereichen der Substratoberfläche prozessiert worden ist, aber vor dem Vereinzeln der Chips. Dabei dringt die Galvaniklösung über geeignete Zugangsöffnungen in die Kavernen unterhalb der Chips ein. Da die Kavernen in einem Halbleitersubstrat ausgebildet sind, stellt die Kavernenwandung und damit auch die Membranunterseite bzw. Chiprückseite eine leitfähige Oberfläche dar, an der sich Metall abscheidet.

In Anbetracht der Tatsache, dass Chips in der Regel auch elektrische Schaltelemente umfassen, wird in einer bevorzugten Variante des erfindungsgemäßen Verfahrens ein stromloser bzw. chemischer Galvanikprozess verwendet. Damit lassen sich in vorteilhafter Weise Nickel-Gold-Schichten oder Nickel-Paladium-Gold-Schichten erzeugen, die sehr gute Hafteigenschaften auf den üblicherweise verwendeten Halbleitermaterialien haben und sehr druckbeständig sind.

In einer vorteilhaften Variante des erfindungsgemäßen Verfahrens wird vor dem Galvanikprozess eine Diffusionsbarriereschicht auf der Chiprückseite erzeugt, um zu verhindern, dass das Halbleitersubstrat und insbesondere die Chiprückseite während des Galvanikprozesses unerwünschterweise dotiert wird. Als Schichtmaterialien für eine solche Diffusionsbarriere eignen sich beispielsweise Cr, Ti oder auch Ti/TiN. Diese Materialien können einfach mit einem CVD-Verfahren auf der strukturierten Oberfläche des Halbleitersubstrats abgeschieden werden, wobei auch die Kavernenwandung und damit auch die Chiprückseite beschichtet wird. In der Regel wird die Diffusionsbarriereschicht dann strukturiert. So kann die Diffusionsbarriereschicht beispielsweise durch einfaches gerichtetes Rücksputtern vollständig von der Chipoberfläche entfernt werden, während sie auf der Kavernenwandung unter der Membran und damit auch auf der Chiprückseite verbleibt.

Da bei dem erfindungsgemäß eingesetzten Galvanikprozess nicht nur die Chiprückseiten metallisiert werden, sondern alle frei zugänglichen leitfähigen Oberflächen, muss die Chipoberseite vor dem Galvanikprozess mit einer geeigneten Passivierschicht versehen werden, wenn sie überhaupt nicht oder nur bereichsweise metallisiert werden soll.

Grundsätzlich kann die als Chip-Ausgangsmaterial fungierende Membran mit einem beliebigen Verfahren in der Substratoberfläche erzeugt werden, also auch von der Substratrückseite ausgehend mit Verfahren der Bulk-Mikromechanik. Insbesondere für die Herstellung von sehr dünnen Chips wird die Membran aber bevorzugt mit Verfahren der Oberflächenmikromechanik erzeugt. Bei dieser Vorgehensweise kommen Halbleiterprozesse, wie z.B. Epitaxie, zum Einsatz, mit denen zuverlässig monokristalline Chips mit einer vorgegebenen Chipdicke realisiert werden können.

Wurde die Membran mit Verfahren der Oberflächenmikromechanik gefertigt, so wird auch der für den erfindungsgemäßen Galvanikprozess erforderliche Zugang zu der Kaverne unter der Membran vorteilhafterweise von der Substratvorderseite ausgehend erzeugt, indem die Membran im Randbereich des Chips geöffnet wird. Diese Strukturierung der Substratvorderseite wird vorteilhafterweise im Zuge des Vereinzelungsverfahrens vorgenommen.

Insbesondere bei der Herstellung von dünnen Chips erweist es sich als vorteilhaft, beim Erzeugen der Membran über der Kaverne mindestens eine Stützstelle auszubilden, über die die Membran mit dem Kavernenboden verbunden ist. Durch geeignete Anordnung einer oder mehrerer solcher Stützstellen kann eine Membrandurchbiegung vermieden werden, die sich beim nachfolgenden Prozessieren der Chips, insbesondere bei Lithographieprozessen, störend auswirkt. Außerdem verhindern derartige Stützstellen, dass sich die Membran aufgrund von Schichten, die im Rahmen der Chipprozessierung nachträglich aufgebracht werden, verbiegt. Dadurch kann gewährleistet werden, dass bei dem nachfolgenden Galvanikprozess eine gleichmäßige Metallisierung auf der Chiprückseite entsteht.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die dem unabhängigen Patentanspruch 1 nachgeordneten Patentansprüche und andererseits auf die nachfolgende Beschreibung zweier Ausführungsbeispiele der Erfindung anhand der Zeichnungen verwiesen.
- **Fig. 1a**: zeigt eine schematische Schnittdarstellung durch ein erstes Halbleitersubstrat entlang der in Fig. 1b dargestellten Schnittebene B-B, nachdem Membranbereiche in der Substratoberfläche erzeugt worden sind, und
- **Fig. 1b**: zeigt eine entsprechende Draufsicht auf dieses erste Halbleitersubstrat entlang der in Fig. 1a dargestellten Schnittebene A-A;
- **Fig. 2**: zeigt eine schematische Schnittdarstellung des ersten Halbleitersubstrats nach einem Trenchprozess zum Vereinzeln der Chips;
- **Fig. 3**: zeigt eine schematische Schnittdarstellung des ersten Halbleitersubstrats nach dem erfindungsgemäßen Galvanikprozess;
- **Fig. 4**: zeigt eine schematische Schnittdarstellung des ersten Halbleitersubstrats nach dem Abpicken eines Chips;
- **Fig. 5**: zeigt eine schematische Schnittdarstellung eines so vereinzelten Chips beim Aufbringen auf einen Träger;
- **Fig. 6a**: zeigt eine schematische Schnittdarstellung durch ein zweites Halbleitersubstrat entlang der in Fig. 6b dargestellten Schnittebene D-D, nachdem Membranbereiche in der Substratoberfläche erzeugt worden sind und nach einem Trenchprozess zum Vereinzeln der Chips, und
- **Fig. 6b**: zeigt eine entsprechende Draufsicht auf dieses zweite Halbleitersubstrat entlang der in Fig. 6a dargestellten Schnittebene C-C.

### Ausführungsformen der Erfindung

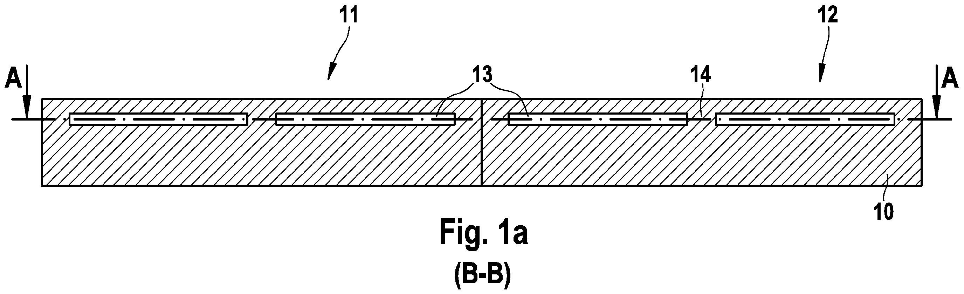

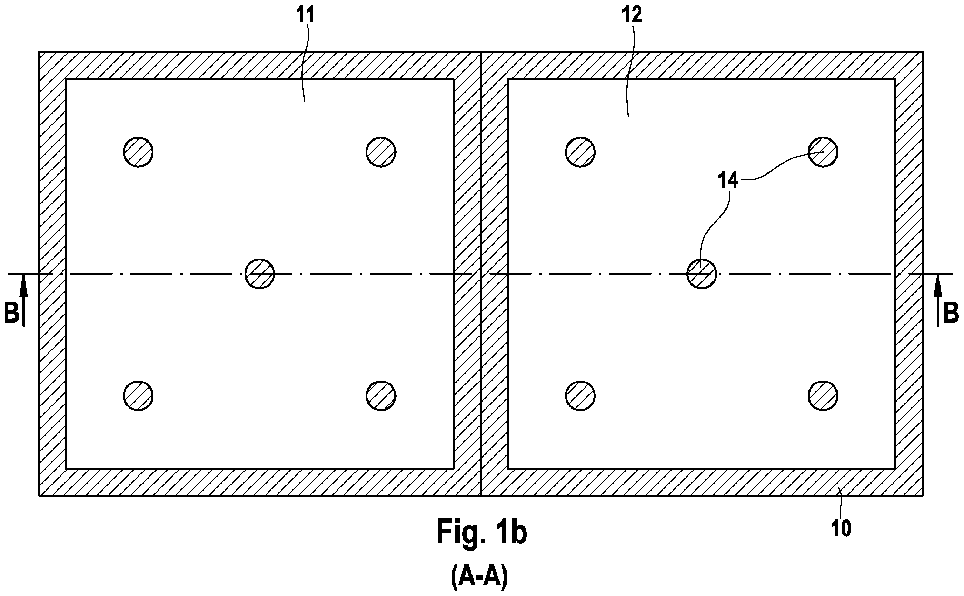

Die **Figuren 1a** und **1b** zeigen ein Halbleitersubstrat 10, in dessen Oberflächenschicht mit Verfahren der Oberflächenmikromechanik Membranbereiche 11 und 12 erzeugt worden sind. Jeder Membranbereich 11, 12 überspannt eine Kaverne 13 und ist über fünf Stützstellen 14 mit dem Kavernenboden verbunden, was insbesondere durch die Schnittdarstellung der Fig. 1a verdeutlicht wird, während Fig. 1b die Anordnung der Stützstellen 14 in den Membranbereichen 11, 12 wiedergibt. Die Stützstellen 14 unterstützen und stabilisieren die Membranbereiche 11, 12. Sie sorgen dafür, das die Membranbereiche 11, 12 während des anschließenden Halbleiterprozesses, bei dem die Funktionalität eines Chips in die Membranbereiche 11, 12 integriert wird, hinreichend eben sind. Dabei sind Form, Anzahl und Lage der Stützstellen beliebig und werden vorteilhafterweise an die Größe und Form der Membranbereiche angepasst. Jedoch sollte der Säulendurchmesser oder die "Mauerstärke" im Fall von "Stützmauern" höchstens in der Größenordnung der Membrandicke liegen.

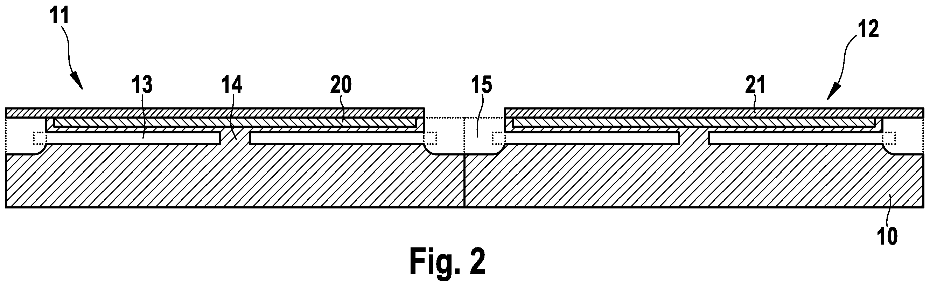

Das hier beschriebene Ausführungsbeispiel bezieht sich auf die Herstellung von sehr dünnen Chips. Dazu wurde eine Halbleiterschaltung 20 mit Leiterbahnen und Bondpads direkt in die Substratoberfläche der Membranbereiche 11, 12 diffundiert und mit einer Passivierschicht 21 geschützt. Zur Vereinzelung der so gefertigten Chips 1, 2 werden die Membranbereiche 11, 12 zunächst aus ihrem lateralen Verbund gelöst, was in **Fig. 2** dargestellt ist. Dazu wurden am Rand der Membranbereiche 11, 12 Trenchgräben 15 erzeugt, die in die Kavernen 13 unterhalb der Membranbereiche 11, 12 münden und so Zugangsöffnungen zu den Kavernen 13 bilden. Danach sind die einzelnen Chips 1, 2 nur noch über die Stützstellen 14 mit dem Substrat 10 verbunden. Für das laterale Abtrennen der Chips 1, 2 kann grundsätzlich auch ein anderes Verfahren verwendet werden, jedoch können in einem Trenchprozess einfach die unterschiedlichsten Chipgeometrien realisiert werden, insbesondere auch sechseckige oder runde Formen.

Die Maske bei diesem Trenchschritt zur Vereinzelung deckt die gesamte Chipfläche inklusive der metallischen Bondpads ab. Wird die Maske entfernt, entsteht bei der nachfolgenden stromlosen Galvanik auch auf den metallischen Bondpads eine galvanische Abscheidung. Wird die Maske auf den Chips belassen, so wird kein Metall auf den Bondpads abgeschieden.

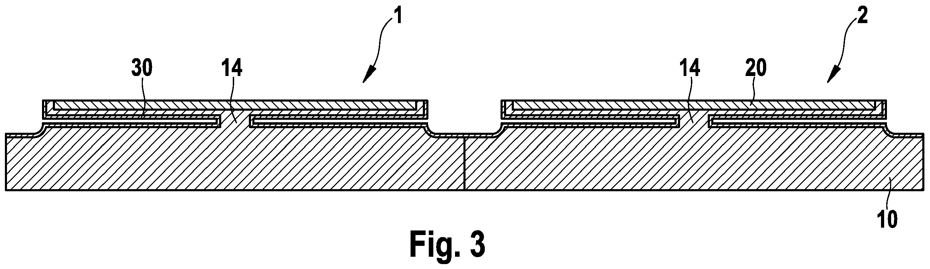

Nun wurde das gesamte Halbleitersubstrat 10 einem stromlosen Galvanikprozess unterzogen. Dabei wurden alle frei zugänglichen elektrisch leitfähigen Oberflächen metallisiert. Vor der Galvanik kann eine Diffusionsbarriere abgeschieden und strukturiert werden. Dementsprechend hat sich auch auf den Seitenwänden der Trenchgräben 15 sowie auf den Kavernenwandungen und damit auch auf den Chiprückseiten und Chipkanten eine Metallisierung 30 gebildet, wie in **Fig. 3** dargestellt.

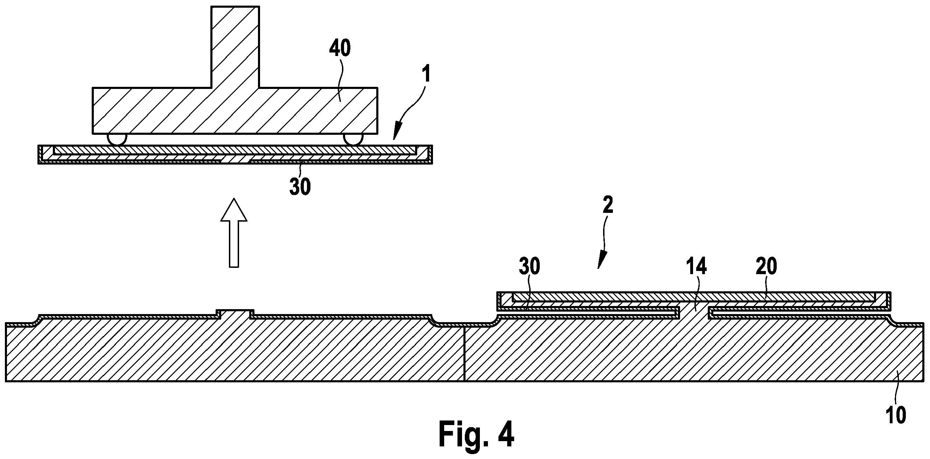

Erst danach werden die einzelnen Chips 1, 2 mit einem Werkzeug 40 vom Substrat 10 abgenommen, was in **Fig. 4** dargestellt ist. Das Abreißen der Stützstellen 14 kann durch eine Schwingbewegung des Werkzeugs 40 verbessert werden, wie z.B. durch Ultraschallschwingen in x, y oder z-Richtung oder durch Torsionsschwingungen.

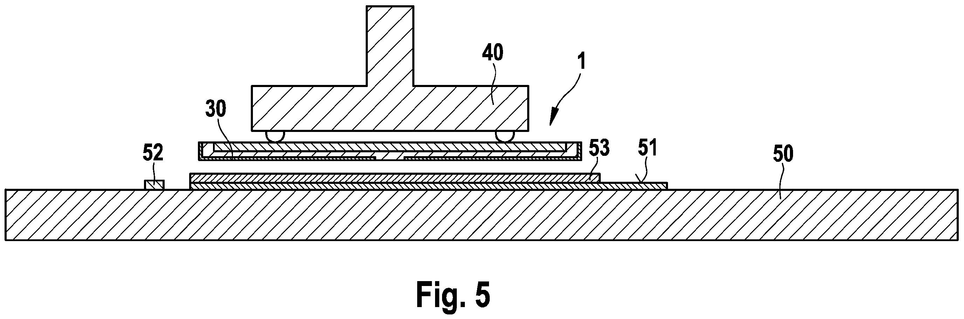

In **Fig. 5** ist dargestellt, wie ein so vereinzelter rückseitenmetallisierter Chip 1 mit dem Werkzeug 40 auf einen Träger 50 aufgebracht wird. Dieser Träger 50, bei dem es sich beispielsweise um eine Keramik- oder LCP-Platte handeln kann, ist mit einer strukturierten Metallisierung versehen, in der zum einen eine Montagefläche 51 für den Chip 1 und zum anderen auch Leiterbahnen 52 ausgebildet sind. Der Chip 1 wird in einem Lötprozess, z.B. Reflowlöten, auf der Montagefläche 51 montiert und so fest mit dem Träger 50 verbunden. Die Rückseitenmetallisierung 30, die bei dem Lötprozess entstehende Verbindungs-Lotschicht 53 und die Metallisierung 51 der Montagefläche gewährleistet eine hervorragende thermische Anbindung des Chips 1 an den Träger 50. Der Träger 50 kann so auch als Wärmesenke dienen. Dazu besteht der Träger 50 vorteilhafterweise aus einem gut wärmeleitenden Material. Zur besseren Wärmeableitung kann der Träger auch gekühlt sein.

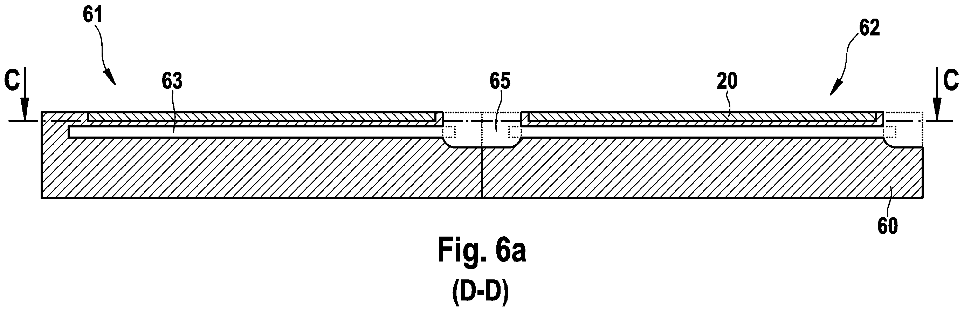

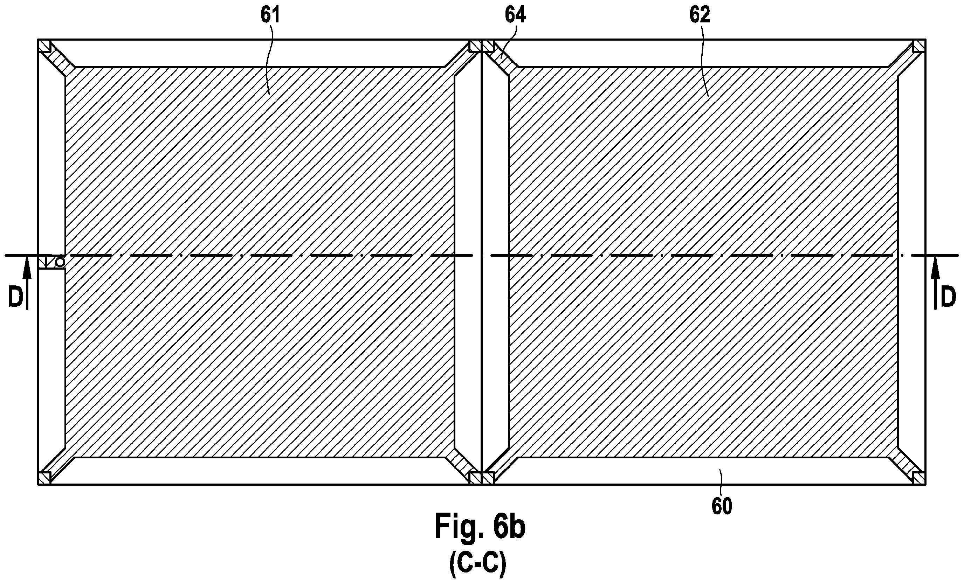

Die **Figuren 6a** und **6b** zeigen ein Halbleitersubstrat 60, in dessen Oberflächenschicht ebenfalls mit Verfahren der Oberflächenmikromechanik quadratische Membranbereiche 61 und 62 erzeugt worden sind, die jeweils eine Kaverne 63 überspannen. Danach wurde auf den Membranbereichen 61, 62 die gewünschte Chipfunktionalität erzeugt. Erst dann wurden die Chips 1, 2 in einem Trenchprozess aus ihrem lateralen Verbund gelöst. Im hier dargestellten Ausführungsbeispiel verblieben dabei allerdings seitliche Stege 64, die in den Membranecken ausgebildete sind, aber auch im Bereich der Kanten, vorzugsweise in der Kantenmitte, angeordnet sein können. Über diese Stege 64 sind die Chips 1 und 2 auch nach dem Trenchprozess noch mit dem Substrat 60 verbunden. Nun erfolgt die Metallisierung der Chiprückseite in einem Galvanikprozess, bei dem die Galvaniklösung über die Trenchgräben 65 in die Kavernen 63 eindringt. Erst danach werden die Chips 1, 2 in einem mechanischen Abgreifprozess, bei dem die seitlichen Stege 64 aufgebrochen werden, vom Substrat 60 gelöst. Zum Vereinfachen des Abgreifprozesses können die Stege 64 auch mit einer Sollbruchstelle, beispielsweise in Form einer Perforation, ausgebildet werden.

Das erfindungsgemäße Verfahren ermöglicht die Fertigung von sehr dünnen Chips mit einer metallisierten Rückseite zur besseren Wärmeabfuhr und mit einer vorgebbaren Dicke im Bereich von 1 bis 100µm. Diese sehr dünnen Chips sind aufgrund der Rückseitenmetallisierung lötbar und können auf diese Weise sehr gut thermisch an einen Träger angebunden werden. Derartige sehr dünne Chips können in vorteilhafter Weise als Hoch- und Mitteldrucksensoren auf einem Stahlsockel mit einer Membran eingesetzt werden. Der hohe thermische Ausdehnungskoeffizient von Stahl wird in diesem Fall dem dünnen Halbleiterchip aufgezwungen, der in der Regel einen wesentlich kleineren Ausdehnungskoeffizienten hat. Da der Chip sehr dünn ist, kann er sich elastisch verformen, ohne bei Temperaturwechseln zerstört zu werden oder die Befestigungsschicht zu zerstören. Mit derartigen dünnen Chips können neben Drucksensoren auch Kraft-, Torsions- oder Drehmomentsensoren hergestellt werden, mit denen beispielsweise der mechanische Stress in beliebigen Stahlelementen gemessen werden kann.

Des Weiteren können mit dem erfindungsgemäßen Verfahren einfach beliebige Chipgeometrien realisiert werden. Die Vereinzelung erfolgt hier, ohne Wassereinwirkung und ohne dass Partikel entstehen, wie bei einem Sägeprozess. Schließlich kann das Halbleitersubstrat, das als Ausgangsmaterial für das erfindungsgemäße Verfahren dient, auch wiederverwendet werden, wenn die beim Galvanikprozess entstandene Metallschicht entfernt wird.

## Patentansprüche

1. Verfahren zur Herstellung von Chips (1, 2) ausgehend von einem Halbleitersubstrat (10),
- bei dem in der Oberflächenschicht des Substrats (10) mindestens eine Membran (11, 12) erzeugt wird, die eine Kaverne (13) überspannt,
- bei dem eine Halbleiterschaltung (20) in die Membran (11,12) integriert wird, und
- bei dem die Membran (11, 12) aus dem Substratverbund gelöst wird, um den Chip (1, 2) zu vereinzeln,
**dadurch gekennzeichnet, dass** die Chiprückseite vor dem Herauslösen des Chips (1, 2) aus dem Substratverbund in einem Galvanikprozess metallisiert wird.

2. Verfahren nach Anspruch 1, **dadurch gekennzeichnet, dass** die Chiprückseite in einem stromlosen Galvanikprozess metallisiert wird.

3. Verfahren nach einem der Ansprüche 1 oder 2, **dadurch gekennzeichnet, dass** eine Nickel-Gold-Schicht (30) oder eine Nickel-Palladium-Gold-Schicht auf der Chiprückseite erzeugt wird.

4. Verfahren nach einem der Ansprüche 1 bis 3, **dadurch gekennzeichnet, dass** vor dem Galvanikprozess auf der Chiprückseite eine Diffusionsbarriereschicht abgeschieden wird.

5. Verfahren nach Anspruch 4, **dadurch gekennzeichnet, dass** die Diffusionsbarriereschicht in einem CVD-Verfahren erzeugt wird und auf der Chipvorderseite strukturiert wird.

6. Verfahren nach einem der Ansprüche 4 oder 5, **dadurch gekennzeichnet, dass** eine Cr-, Ti- oder Ti/TiN-Schicht als Diffusionsbarriereschicht verwendet wird.

7. Verfahren nach einem der Ansprüche 1 bis 6, **dadurch gekennzeichnet, dass** die Chipoberseite vor dem Galvanikprozess mit einer Passivierschicht (21) versehen wird.

8. Verfahren nach einem der Ansprüche 1 bis 7, **dadurch gekennzeichnet, dass** die Membran (11, 12) mit Verfahren der Oberflächenmikromechanik erzeugt wird.

9. Verfahren nach Anspruch 8, **dadurch gekennzeichnet, dass** die Membran (11, 12) im Randbereich geöffnet wird, um einen Zugang zu der Kaverne (13) unterhalb der Membran (11, 12) und damit zur Chiprückseite zu erzeugen.

10. Verfahren nach einem der Ansprüche 8 oder 9, **dadurch gekennzeichnet, dass** beim Erzeugen der Membran (11, 12) über der Kaverne (13) mindestens eine Stützstelle (14) ausgebildet wird, über die die Membran (11, 12) mit dem Kavernenboden verbunden ist.

## Claims

1. Method for producing chips (1, 2) proceeding from a semiconductor substrate (10),
- wherein at least one membrane (11, 12) spanning a cavity (13) is produced in the surface layer of the substrate (10),
- wherein a semiconductor circuit (20) is integrated into the membrane (11, 12), and
- wherein the membrane (11, 12) is detached from the substrate assemblage in order to singulate the chip (1, 2),
**characterized in that** the chip rear side is metallized in a plating process before the chip (1, 2) is detached from the substrate assemblage.

2. Method according to Claim 1, **characterized in that** the chip rear side is metallized in an electroless plating process.

3. Method according to either of Claims 1 and 2, **characterized in that** a nickel-gold layer (30) or a nickel-palladium-gold layer is produced on the chip rear side.

4. Method according to any of Claims 1 to 3, **characterized in that** a diffusion barrier layer is deposited before the plating process on the chip rear side.

5. Method according to Claim 4, **characterized in that** the diffusion barrier layer is produced in a CVD method and is structured on the chip front side.

6. Method according to either of Claims 4 and 5, **characterized in that** a Cr, Ti or Ti/TiN layer is used as the diffusion barrier layer.

7. Method according to any of Claims 1 to 6, **characterized in that** the chip top side is provided with a passivation layer (21) before the plating process.

8. Method according to any of Claims 1 to 7, **characterized in that** the membrane (11, 12) is produced by surface micromachining methods.

9. Method according to Claim 8, **characterized in that** the membrane (11, 12) is opened in the edge region in order to produce an access to the cavity (13) below the membrane (11, 12) and thus to the chip rear side.

10. Method according to either of Claims 8 and 9, **characterized in that** during the process of producing the membrane (11, 12) above the cavity (13), at least one supporting location (14) is formed, via which the membrane (11, 12) is connected to the bottom of the cavity.

## Revendications

1. Procédé de fabrication de puces (1, 2) à partir d'un substrat en semiconducteur (10),
- selon lequel au moins une membrane (11, 12), qui couvre une caverne (13), est générée dans la couche de surface du substrat (10),
- selon lequel un circuit en semiconducteur (20) est intégré dans la membrane (11, 12), et
- selon lequel la membrane (11, 12) est détachée du composé du substrat afin de séparer la puce (1, 2),
**caractérisé en ce que** le côté arrière de la puce est métallisé au cours d'un processus de galvanisation avant de détacher la puce (1, 2) du composé du substrat.

2. Procédé selon la revendication 1, **caractérisé en ce que** le côté arrière de la puce est métallisé au cours d'un processus de galvanisation sans courant.

3. Procédé selon l'une des revendications 1 ou 2, **caractérisé en ce qu'**une couche de nickel-or (30) ou une couche de nickel-palladium-or est générée sur le côté arrière de la puce.

4. Procédé selon l'une des revendications 1 à 3, **caractérisé en ce qu'**une couche de barrière de diffusion est déposée sur le côté arrière de la puce avant le processus de.galvanisation.

5. Procédé selon la revendication 4, **caractérisé en ce que** la couche de barrière de diffusion est générée au cours d'un processus CVD et est structurée sur le côté avant de la puce.

6. Procédé selon l'une des revendications 4 ou 5, **caractérisé en ce qu'**une couche de Cr, de Ti ou de Ti/TiN est utilisée comme couche de barrière de diffusion.

7. Procédé selon l'une des revendications 1 à 6, **caractérisé en ce que** le côté supérieur de la puce est pourvu d'une couche de passivation (21) avant le processus de galvanisation.

8. Procédé selon l'une des revendications 1 à 7, **caractérisé en ce que** la membrane (11, 12) est générée avec des procédés de la micromécanique de surface.

9. Procédé selon la revendication 8, **caractérisé en ce que** la membrane (11, 12) est ouverte dans la zone de bordure afin de générer un accès à la caverne (13) au-dessous de la membrane (11, 12) et ainsi au côté arrière de la puce.

10. Procédé selon l'une des revendications 8 ou 9, **caractérisé en ce qu'**au moins un point d'appui (14) est formé lors de la génération de la membrane (11, 12) au-dessus de la caverne (13), par le biais duquel la membrane (11, 12) est reliée au fond de la caverne.
